(19) Europäisches Patentamt
European Patent Office
Office européen des brevets

(11) EP 3 385 727 A1

(12) EUROPÄISCHE PATENTANMELDUNG

(43) Veröffentlichungstag:
10.10.2018 Patentblatt 2018/41

(51) Int Cl.:
G01R 15/08 (2006.01)     G01R 15/18 (2006.01)
G01R 15/20 (2006.01)     G01D 3/024 (2006.01)
G01R 33/00 (2006.01)

(21) Anmeldenummer: 17165542.6

(22) Anmeldetag: 07.04.2017

(84) Benannte Vertragsstaaten:
AL AT BE BG CH CY CZ DE DK EE ES FI FR GB
GR HR HU IE IS IT LI LT LU LV MC MK MT NL NO
PL PT RO RS SE SI SK SM TR
Benannte Erstreckungsstaaten:
BA ME
Benannte Validierungsstaaten:
MA MD

(71) Anmelder: Siemens Aktiengesellschaft
80333 München (DE)

(72) Erfinder:
• Chahid, Abderrahim
  91334 Hemhofen (DE)
• Hoffmann, Ingolf
  91074 Herzogenaurach (DE)
• Itzke, Alexander
  90762 Fürth (DE)
• Weiß, Roland
  91058 Erlangen (DE)

(54) **VERFAHREN ZUR STROMMESSUNG UND STROMMESSVORRICHTUNG**

(57)     Die Erfindung betrifft eine Strommessvorrichtung (1). Zur Verbesserung der Messgenauigkeit wird vorgeschlagen, dass die Strommessvorrichtung (1) mindestens zwei Sensoren (11) eines ersten Typs und mindestens zwei Sensoren (12) eines zweiten Typs aufweist, wobei die Sensoren (11) des ersten Typs eine höhere Empfindlichkeit aufweisen als die Sensoren (12) des zweiten Typs, wobei die ersten Sensoren (11) radialsymmetrisch auf einer ersten Kreisbahn ($K_1$) und die zweiten Sensoren (12) radialsymmetrisch auf einer zweiten Kreisbahn ($K_2$) angeordnet sind, wobei jeweils ein Sensor (11) des ersten Typs benachbart zu einem Sensor (12) des zweiten Typs ange-ordnet ist. Weiter betrifft die Erfindung ein Verfahren zur Strommessung mittels einer solchen Strommessvorrichtung, wobei zur Bestimmung der Stromstärke mindestens einer der Sensoren (11) des ersten Typs ausgewertet wird, falls die Messwerte mindestens zweier Sensoren (11) des ersten Typs innerhalb des Messbereichs liegen und ansonsten mindestens ein Sensor (12) des zweiten Typs ausgewertet wird.

FIG 1

EP 3 385 727 A1

**Beschreibung**

Die Erfindung betrifft eine Strommessvorrichtung. Weiter betrifft die Erfindung ein Verfahren zur Strommessung mittels einer solchen Strommessvorrichtung.

Strommessvorrichtungen, auch als Stromsensoren bezeichnet, werden angewendet, um an bestimmten Stellen innerhalb von elektrischen Anlagen Ströme zu messen bzw. zu bestimmen. Dabei wird eine Sensoranordnung für eine Strommessvorrichtung und ein entsprechendes Auswerteverfahren betrachtet, die eine energieeffiziente Messung von Strömen zwischen 400A und 10kA ohne Flusskonzentrator (Flusskreises) ermöglichen. Diese Sensoranordnung kommt ohne Eisenkreis aus und ermöglicht eine im Vergleich zum Stand der Technik verbesserte Störempfindlichkeit gegenüber den Feldern paralleler Störleiter wie sie in einem Drei-Phasen-Drehstromsystem üblich sind. Solche Stromsensoren können Anwendung in Umrichtern für Nieder- und Mittelspannung oder in Batterieüberwachung finden. Vor allem Umrichter für Schiffs- und Bahnantriebe oder Windkraftanlagen bewegen sich in diesem Strombereich und werden häufig so kompakt aufgebaut, dass hohe Fremdfelder, aber auch überlagerte Eigenfelder (Stromschienenrückführung) am Ort der Strommessung üblich sind. Infolge des "open loop"-Betriebs wird der Messbereich der Sensoranordnung durch den Messbereich des einzelnen Sensors begrenzt. Darüber hinaus weisen die Magnetfeldsensoren, die den für die Maximalfelder nötigen Messbereich besitzen, (ca. 50mT) einen relativ großen Offset-Fehler von deutlich über 1% des Maximalwertes auf. In diesem Feldbereich arbeiten fast ausschließlich Hall-Sensoren, welche für ihre Offset-Fehler bekannt sind. Da sich der Offset-Fehler der Einzelsensoren mit der Temperatur und über die Zeit ändert, ist eine zusätzliche analoge oder digitale Offset-Stabilisierung schwierig.

Bisher wird der Strom z.B. mit Shuntwiderständen, Ringkernwandlern, Rogowskispulen oder einzelnen Feldsonden (Hallsonde oder GMR-Sensor) gemessen. Bei den bisher bekannten Messaufbauten wird der vergleichsweise große Offsetfehler und die damit verbundene geringe Genauigkeit bei kleinen Strömen akzeptiert. Dabei ist zu erwähnen, dass eine einfache direkte Kompensation des beobachteten Offsetfehlers wegen dessen nicht deterministischen Zeitverhaltens und des stark nichtlinearen Temperaturverhaltens nur schwer möglich ist. Der Messbereich der Sensoranordnung ergab sich aus dem Messbereich der verfügbaren Einzelsensoren. Da die verfügbare Hall-Technologie Sensoren bei einem Messbereich von ca. 25mT und größer eine sehr gute Genauigkeit ermöglichen und die alternativ dazu verfügbare MR-Technologie nur Sensoren mit einem Messbereich bis 1mT ermöglicht, bestand lange eine große Lücke im Messbereich für "Chip-scale" Magnetfeld Sensoren. Darüber hinaus dekalibrierten die MR-Sensoren bei Feldern von größer ca. 20mT in einem Maße, das die Genauigkeit deutlich verschlechtert.

Der Erfindung liegt die Aufgabe zugrunde, eine Strommessvorrichtung anzugeben, die eine höhere Genauigkeit bei der Strommessung ermöglicht.

Diese Aufgabe wird durch eine Strommessvorrichtung aufweisend mindestens zwei Sensoren eines ersten Typs und mindestens zwei Sensoren eines zweiten Typs gelöst, wobei die Sensoren des ersten Typs eine höhere Empfindlichkeit aufweisen als die Sensoren des zweiten Typs, wobei die ersten Sensoren radialsymmetrisch auf einer ersten umlaufenden Bahn, insbesondere einer Ellipse oder einer ersten Kreisbahn, und die zweiten Sensoren radialsymmetrisch auf einer zweiten umlaufenden Bahn, insbesondere einer Ellipse oder einer zweiten Kreisbahn, angeordnet sind, wobei jeweils ein Sensor des ersten Typs benachbart zu einem Sensor des zweiten Typs angeordnet ist. Weiter wird diese Aufgabe durch ein Verfahren zur Strommessung mittels einer solchen Strommessvorrichtung gelöst, wobei zur Bestimmung der Stromstärke einer der Sensoren des ersten Typs ausgewertet wird falls die Messwerte mindestens zweier Sensoren des ersten Typs innerhalb des Messbereichs liegen und ansonsten mindestens einer der Sensoren des zweiten Typs ausgewertet wird.

Weitere vorteilhafte Ausgestaltungen der Erfindung sind in den abhängigen Ansprüchen angegeben.

Der Erfindung liegt die Erkenntnis zugrunde dass sich die Messgenauigkeit einer ringförmigen Anordnung von Einzelsensoren dadurch verbessern, dass jeweils an der Messstelle bzw. den Messstellen Sensoren unterschiedlichen Typs so angeordnet werden, dass sie zum Einen in möglichst direkter Nähe zu einander sind und zum Anderen alle Sensoren eines Typs eine eigenständige, möglichst radialsymmetrische Messanordnung bilden. Dabei sind die beiden Sensoren unterschiedlichen Typs an einer Messstelle benachbart zueinander angeordnet. Das bedeutet, dass ihr Abstand zueinander geringer ist als eine Ausdehnung eines der Sensoren. Neben einer Verbesserung der Messgenauigkeit kann durch diese Anordnung zudem der Messbereich erweitert werden. Dabei können die Sensoren unterschiedlichen Typs tangential oder radial benachbart angeordnet sein.

Mit Empfindlichkeit, auch als Auflösung bezeichnet, versteht man die Eigenschaft, eine Veränderung eines Messwertes erfassen zu können. Je höher die Empfindlichkeit, desto geringere Veränderungen der Messgröße lassen sich damit erfassen.

Die Erweiterung des Messbereichs sowie die Erhöhung der Messgenauigkeit durch die Strommessvorrichtung lassen sich durch ein Verfahren zur Strommessung erreichen. Dabei lassen sich diese Vorteile durch eine vorteilhafte Umschaltmethode zwischen den Sensoren unterschiedlichen Typs erreichen. Durch Untersuchungen auf Basis von realen Messdaten, unter Berücksichtigung von Störungen durch weitere stromführende Leiter, konnte gezeigt werden, dass eine typenweise Sensor-Umschaltung allen anderen Methoden in signifikantem Maße überlegen ist. Die typenweise Sensor-Umschaltung erfolgt derart, dass alle Sensoren vom ersten Typ mit einer hohen Empfindlichkeit immer dann zur Berechnung des Stromwertes verwendet werden, wenn mehrere Sensoren, d.h. mindestens zwei Sensoren, vom ersten Typ jeweils individuelle gültige Werte innerhalb Ihres Messbereiches liefern. Dabei sind individuell gültige Messwerte diejenigen, die innerhalb des zulässigen Messbereichs des Sensors liegen. Ansonsten werden immer die Sensoren vom zweiten Typ zur Berechnung des Stromwertes verwendet. Das heißt, wenn sich mindestens zwei Sensoren vom ersten Typ gleichzeitig innerhalb ihres Magnetfeld-Messbereiches befinden, werden die Signale der Sensoren vom ersten Typ zur Stromberechnung verwendet ansonsten werden die Signale der Sensoren vom zweiten Typ zur Stromberechnung verwendet.

Die Sensoren vom ersten Typ und vom zweiten Typ bilden dabei jeweils zwei konzentrische ringförmige Anordnungen von Sensoren mit paralleler Ausrichtung der feldempfindlichen Richtung. Bei Übersteuern eines einzelnen Sensors findet jedoch keine sensorweise Umschaltung statt. Um gute Messergebnisse zu erzielen, wird eine typenweise Umschaltung vorgenommen. Die Vorteile dieses Verfahrens liegen in einer Erweiterung des Messbereiches, einer generellen Erhöhung der Genauigkeit und einer möglichen Reduktion des Offsetfehlers.

Bei einer vorteilhaften Ausgestaltung der Erfindung weisen die Sensoren des ersten Typs eine um den Faktor 5 bis 20 höhere Empfindlichkeit auf als die Sensoren des zweiten Typs. Es hat sich gezeigt, dass sich hiermit ein besonders geringer Offsetfehler erreichen lässt. Ist die Empfindlichkeit der Sensoren vom ersten Typ um den Faktor von 5 bis 20 verglichen mit den Sensoren vom zweiten Typ größer, lässt sich in der Praxis bezogen auf den Messbereich ein sehr kleiner Offsetfehler erreichen. Damit lassen sich die Messbereiche der einzelnen Sensoren unterschiedlicher Typen auf sinnvolle Weise derart staffeln, um den Messfehler gering zu halten.

Bei einer weiteren vorteilhaften Ausgestaltung der Erfindung sind die Sensoren des ersten Typs Flux-Gate Feldsensoren und die Sensoren des zweiten Typs Hall-Sensoren. Diese Sensoren sind am Markt günstig verfügbar. Darüber hinaus ist deren Baugröße entsprechend klein, so dass diese sich auf einfache Weise in eine Messvorrichtung integrieren lassen.

Bei einer weiteren vorteilhaften Ausgestaltung der Erfindung wird zur Bestimmung der Stromstärke mindestens einer der Sensoren des ersten Typs ausgewertet, falls die Messwerte aller Sensoren des ersten Typs innerhalb des Messbereichs liegen und ansonsten wird mindestens einer der Sensoren des zweiten Typs ausgewertet.

Dies bedeutet, dass sobald ein Messwert eines der Sensoren des ersten Typs seinen Messbereich verlässt, der Strom durch mindestens einen Sensor des zweiten Typs, insbesondere durch eine gewichtete Summe über die Sensoren des zweiten Typs, berechnet. Erst wenn die Messwerte aller Sensoren vom ersten Typ aus dem gültigen Bereich stammen, wird der Stromwert über mindestens einen der Sensoren des ersten Typs, insbesondere über eine gewichtete Summe über die Sensoren des ersten Typs, berechnet. Damit tragen alle Sensoren zur verbesserten Strombestimmung bei und es kann ein Messwert mit einer besonders hohen Genauigkeit bestimmt werden.

Bei einer weiteren vorteilhaften Ausgestaltung der Erfindung wird während der Bestimmung der Stromstärke durch die Sensoren des ersten Typs ein Korrekturwert für den Offset der Sensoren des zweiten Typs in Abhängigkeit der Messwerte aus den Sensoren des zweiten Typs, insbesondere zusätzlich in Abhängigkeit der durch die Sensoren des ersten Typs bestimmten Stromstärke, ermittelt. Wird gerade der gültige Stromwert die Sensoren des ersten Typs berechnet, wird parallel dazu in einer Art Nebenrechnung auch der Strom der Sensoren des zweiten Typs berechnet. Die Berechnung kann dabei in beiden und in einem der Fälle über eine gewichtete Summe der Messwerte der einzelnen Sensoren erfolgen. Daraus wird dann ein aktueller Korrekturwert für den Offset der Sensoranordnung des zweiten Typs ermittelt. Dabei bestimmt sich der durch die Sensoren des zweiten Typs gemessene Strom zu

$$I_{Typ\,II} = \sum a_j^{Typ\,II} \cdot S_j^{Typ\,II} - I_{Off,II} - \overline{K_{Off,II}}\,.$$

Daraus ergibt sich ein einzelner Wert für den Korrekturfaktor zu

$$K_{Off,II} = \sum a_j^{Typ\,II} \cdot S_j^{Typ\,II} - I_{Off,II} - \left( \sum a_j^{Typ\,I} \cdot S_j^{Typ\,I} - I_{Off,I} \right).$$

Vorteilhafterweise wird der Korrekturwert für den Offset der Sensoranordnung des zweiten Typs $K_{off\,II}$ in einem möglichst großen Bereich von gültigen Werten der Sensoranordnung des ersten Typs ermittelt. Für die Korrektur des Stromwertes bei gültiger Berechnung über die gewichtete Summe über die Sensoren des zweiten Typs wird dann der Mittelwert der letzten Korrekturwerte für den Offset der Sensoranordnung des zweiten Typs $K_{off\,II}$ verwendet.

Im Folgenden wird die Erfindung anhand der in den Figuren dargestellten Ausführungsbeispiele näher beschrieben und erläutert. Es zeigen:

FIG 1    ein erstes Ausführungsbeispiel einer Strommessvorrichtung,

FIG 2    ein zweites Ausführungsbeispiel einer Strommessvorrichtung und

FIG 3    eine mögliche Realisierung eines Verfahrens zur Offsetkorrektur.

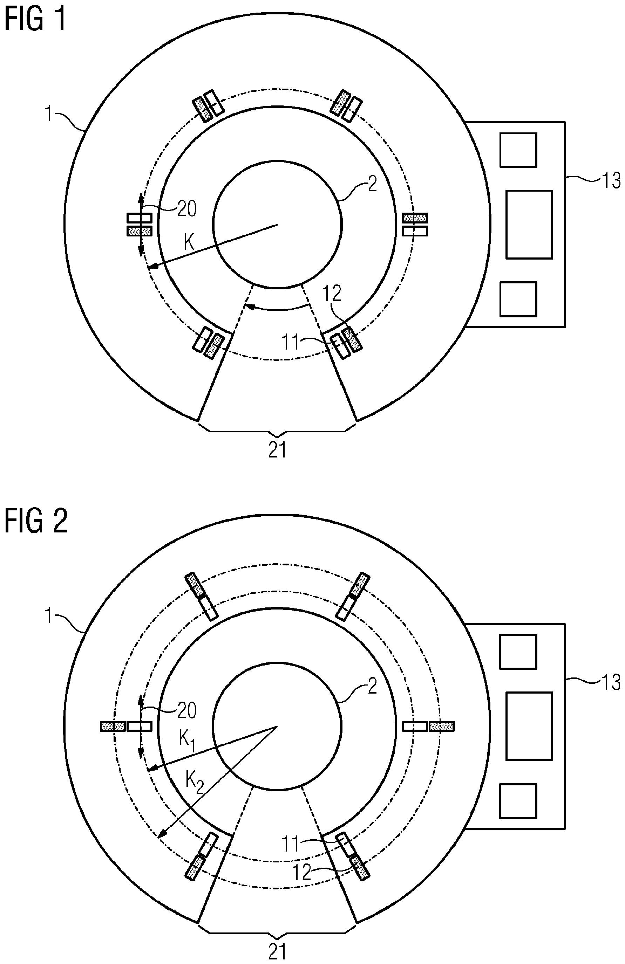

Die FIG 1 zeigt ein erstes Ausführungsbeispiel einer Strommessvorrichtung 1 um einen elektrischen Leiter 2. Die Strommessvorrichtung 1 weist dabei eine Vielzahl Sensoren 11 eines ersten Typs und jeweils benachbart dazu eine Vielzahl Sensoren 12 eines zweiten Typs. Benachbart heißt in diesem Ausführungsbeispiel, dass der Abstand zwischen zwei Sensoren kleiner ist, als die kleinste Ausdehnung der Sensoren. Die Typen unterscheiden sich dabei beispielsweise in ihren Messprinzipien. Die Sensoren unterschiedlichen Typs sind auf einer gemeinsamen Kreisbahn K angeordnet. Dabei erfolgt die Anordnung derart, dass die durch den jeweiligen Sensor messbare Feldausrichtung 20 tangential zur Kreisbahn ausgerichtet ist. Um die Messsignale der einzelnen Sensoren auswerten zu können weist die Strommessvorrichtung 1 eine Auswerteelektronik 13 auf. Um die Messvorrichtung 1 auf einfache Weise um den elektrischen Leiter anzuordnen, hat es sich als vorteilhaft erwiesen im Kreisförmigen Aufbau der Strommessvorrichtung 1 eine winkelförmige Öffnung 21 vorzusehen. Je flexibler die Strommessvorrichtung 1 ist, desto kleiner kann die winkelförmige Öffnung 21 ausgebildet sein.

Die FIG 2 zeigt ein weiteres Ausführungsbeispiel der Strommessvorrichtung 1. Zur Vermeidung von Wiederholungen wird auf die Beschreibung zur FIG 1 und auf die dort eingeführten Bezugszeichen verwiesen. Bei diesem Ausführungsbeispiel sind die Sensoren der unterschiedlichen Typen jeweils auf unterschiedlichen, konzentrischen Kreisbahnen $K_1$, $K_2$ benachbart angeordnet. Benachbart heißt in diesem Ausführungsbeispiel, dass der Abstand zwischen zwei Sensoren kleiner ist, als die kleinste Ausdehnung der Sensoren. Auch mit dieser Anordnung lässt sich vergleichbar gute Messergebnis erzielen wie im Aufbau des vorhergehend erläuterten Ausführungsbeispiels.

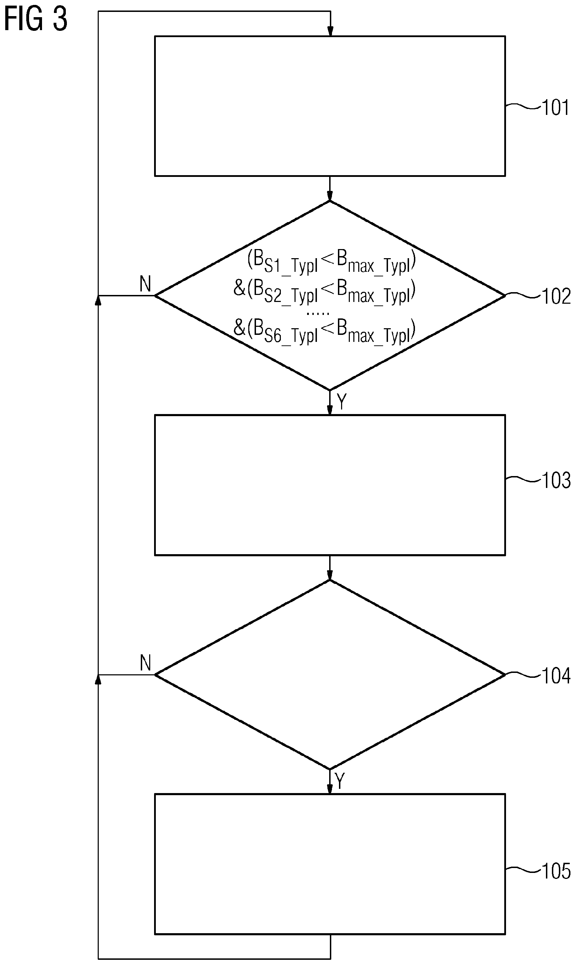

Die FIG 3 zeigt ein Ablaufdiagramm für ein vorteilhaftes Messverfahren für eine Offsetkorrektur. In einem ersten Schritt 101 erfolgt die Strommessung durch die Sensoren des ersten und des zweiten Typs. In einer Entscheidung 102 wird überprüft, ob sich alle Messwerte der Sensoren des ersten Typs im erlaubten Messbereich befinden. Ist dies nicht der Fall, wird im Pfad N (für no) zum ersten Schritt 101 zurückgekehrt und neue Messwerte aufgenommen. Im anderen Fall Y (für yes), in dem die Messwerte der Sensoren des ersten Typs dann im erlaubten Bereich liegen, wird der Offset $K_{offB}$ aus den Werten der Sensoren 12 des zweiten Typs im Schritt 103 bestimmt. Erst bei Erreichen einer Mindestmenge an Werten für $K_{offB}$ wird ein Offsetwert für die Sensoren des zweiten Typs im Schritt 105 festgelegt. Andernfalls sorgt die Entscheidung 104 dafür, dass wieder mit der Bestimmung neuer Messwerte im Schritt 101 fortgefahren wird.

Zusammenfassend betrifft die Erfindung eine Strommessvorrichtung. Zur Verbesserung der Messgenauigkeit wird vorgeschlagen, dass die Strommessvorrichtung mindestens zwei Sensoren eines ersten Typs und mindestens zwei Sensoren eines zweiten Typs aufweist, wobei die Sensoren des ersten Typs eine höhere Empfindlichkeit aufweisen als die Sensoren des zweiten Typs, wobei die ersten Sensoren radialsymmetrisch auf einer ersten Kreisbahn und die zweiten Sensoren radialsymmetrisch auf einer zweiten Kreisbahn angeordnet sind, wobei jeweils ein Sensor des ersten Typs benachbart zu einem Sensor des zweiten Typs angeordnet ist. Weiter betrifft die Erfindung ein Verfahren zur Strommessung mittels einer solchen Strommessvorrichtung, wobei zur Bestimmung der Stromstärke mindestens einer der Sensoren des ersten Typs ausgewertet wird, falls die Messwerte mindestens zweier Sensoren des ersten Typs innerhalb des Messbereichs liegen und ansonsten mindestens ein Sensor des zweiten Typs ausgewertet wird.

**Patentansprüche**

1.    Strommessvorrichtung (1) aufweisend

- mindestens zwei Sensoren (11) eines ersten Typs
- mindestens zwei Sensoren (12) eines zweiten Typs, wobei die Sensoren (11) des ersten Typs eine höhere Empfindlichkeit aufweisen als die Sensoren (12) des zweiten Typs, wobei die ersten Sensoren (11) radialsymmetrisch auf einer ersten umlaufenden Bahn, insbesondere einer Ellipse oder einer ersten Kreisbahn ($K_1$), und die zweiten Sensoren (12) radialsymmetrisch auf einer zweiten umlaufenden Bahn, insbesondere einer Ellipse oder einer zweiten Kreisbahn ($K_2$), angeordnet sind, wobei jeweils ein Sensor (11) des ersten Typs benachbart zu einem Sensor (12) des zweiten Typs angeordnet ist.

2.    Strommessvorrichtung (1) nach Anspruch 1, wobei die Sensoren (11) des ersten Typs eine um den Faktor 5 bis 20 höhere Empfindlichkeit aufweisen als die Sensoren (12) des zweiten Typs.

3.    Strommessvorrichtung (1) nach einem der Ansprüche 1 oder 2, wobei die Sensoren (11) des ersten Typs Flux-Gate Feldsensoren und die Sensoren (12) des zweiten Typs Hall-Sensoren sind.

4. Verfahren zur Strommessung mittels einer Strommessvorrichtung nach einem der Ansprüche 1 bis 3, wobei zur Bestimmung der Stromstärke mindestens einer der Sensoren (11) des ersten Typs ausgewertet wird, falls die Messwerte mindestens zweier Sensoren (11) des ersten Typs innerhalb des Messbereichs liegen und ansonsten mindestens ein Sensor (12) des zweiten Typs ausgewertet wird.

5. Verfahren nach Anspruch 4, wobei zur Bestimmung der Stromstärke mindestens einer der Sensoren (11) des ersten Typs ausgewertet werden falls die Messwerte aller Sensoren (11) des ersten Typs innerhalb des Messbereichs liegen und ansonsten die Sensoren (12) des zweiten Typs ausgewertet werden.

6. Verfahren nach einem der Ansprüche 4 oder 5, wobei während der Bestimmung der Stromstärke durch die Sensoren (11) des ersten Typs ein Korrekturwert für den Offset der Sensoren des zweiten Typs in Abhängigkeit der Messwerte aus den Sensoren (12) des zweiten Typs, insbesondere zusätzlich in Abhängigkeit der durch die Sensoren (11) des ersten Typs bestimmten Stromstärke, ermittelt wird.

FIG 1

FIG 2

FIG 3

```
        ┌─────────────────────────────┐
        │                             │
        │                             │── 101
        │                             │
        └─────────────┬───────────────┘
                      │
                      ▼
              ╱───────────────╲
          ╱                       ╲
      ╱   (B_{S1\_TypI} < B_{max\_TypI})  ╲
  N ╱  & (B_{S2\_TypI} < B_{max\_TypI})    ╲── 102
    ╲           .....                    ╱
      ╲  & (B_{S6\_TypI} < B_{max\_TypI}) ╱
          ╲                       ╱
              ╲───────────────╱
                      │ Y
                      ▼
        ┌─────────────────────────────┐
        │                             │
        │                             │── 103
        │                             │
        └─────────────┬───────────────┘
                      │
                      ▼
              ╱───────────────╲
          ╱                       ╲
    N   ╱                           ╲── 104
        ╲                           ╱
          ╲                       ╱
              ╲───────────────╱
                      │ Y
                      ▼
        ┌─────────────────────────────┐
        │                             │
        │                             │── 105
        │                             │
        └─────────────────────────────┘
```

$(B_{S1\_TypI} < B_{max\_TypI})$
$\&(B_{S2\_TypI} < B_{max\_TypI})$
$.....$
$\&(B_{S6\_TypI} < B_{max\_TypI})$

Europäisches Patentamt
European Patent Office
Office européen des brevets

# EUROPÄISCHER RECHERCHENBERICHT

Nummer der Anmeldung

EP 17 16 5542

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2005/156587 A1 (YAKYMYSHYN CHRISTOPHER P [US] ET AL) 21. Juli 2005 (2005-07-21)<br>* Abbildung 8 *<br>* Absätze [0061] - [0065] *<br>* Absatz [0068] *<br>* Absatz [0073] *<br>* Absatz [0078] *<br>----- | 1-6 | INV.<br>G01R15/08<br>G01R15/18<br>G01R15/20<br>G01D3/024<br><br>ADD.<br>G01R33/00 |
| X | US 2014/218018 A1 (IVANOV MIKHAIL VALERYEVICH [DE] ET AL)<br>7. August 2014 (2014-08-07)<br>* Abbildungen 11, 16 *<br>* Absatz [0036] *<br>* Absatz [0043] *<br>* Absätze [0048] - [0050] *<br>----- | 1-6 | |
| X | US 2010/001716 A1 (SERPINET MARC [FR] ET AL) 7. Januar 2010 (2010-01-07)<br>* Abbildungen 5-9 *<br>* Absatz [0036] *<br>* Absatz [0040] *<br>* Absätze [0043] - [0050] *<br>* Absätze [0054] - [0070] *<br>----- | 1-6 | |
| E | WO 2017/116615 A1 (EVERSPIN TECH INC [US])<br>6. Juli 2017 (2017-07-06)<br>* Abbildungen 1, 2, 6, 9 *<br>* Absatz [0028] *<br>* Absätze [0035] - [0038] *<br>* Absätze [0040] - [0043] *<br>* Absätze [0047] - [0048] *<br>* Absätze [0061] - [0064] *<br>* Zusammenfassung *<br>-----<br>-/-- | 1,4 | RECHERCHIERTE SACHGEBIETE (IPC)<br><br>G01R<br>G01D |

Der vorliegende Recherchenbericht wurde für alle Patentansprüche erstellt

| Recherchenort | Abschlußdatum der Recherche | Prüfer |
|---|---|---|
| München | 7. Dezember 2017 | Danisi, Alessandro |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.........................................................................................
& : Mitglied der gleichen Patentfamilie, übereinstimmendes Dokument

EPO FORM 1503 03.82 (P04C03)

Seite 1 von 2

**Europäisches Patentamt**
**European Patent Office**
**Office européen des brevets**

# EUROPÄISCHER RECHERCHENBERICHT

Nummer der Anmeldung

EP 17 16 5542

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | J. LENZ ET AL: "Magnetic sensors and their applications", IEEE SENSORS JOURNAL., Bd. 6, Nr. 3, 1. Juni 2006 (2006-06-01), Seiten 631-649, XP055417848, US ISSN: 1530-437X, DOI: 10.1109/JSEN.2006.874493 * das ganze Dokument * | 2,3 | |
| A | Slawomir Tumanski: "Magnetic field sensors - Classification" In: "Handbook of Magnetic Measurements", 23. Juni 2011 (2011-06-23), XP055417849, ISBN: 978-1-4398-2951-6 Seiten 159-160, * das ganze Dokument * | 2,3 | |
| A | Anonymous: "DRV425 Fluxgate Magnetic-Field Sensor", , 31. März 2016 (2016-03-31), XP055414701, Gefunden im Internet: URL:http://www.ti.com/lit/ds/sbos729a/sbos729a.pdf [gefunden am 2017-11-30] * das ganze Dokument * | 3,6 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| München | 7. Dezember 2017 | Danisi, Alessandro |

**ANHANG ZUM EUROPÄISCHEN RECHERCHENBERICHT
ÜBER DIE EUROPÄISCHE PATENTANMELDUNG NR.**

EP 17 16 5542

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

07-12-2017

| Im Recherchenbericht angeführtes Patentdokument | Datum der Veröffentlichung | Mitglied(er) der Patentfamilie | Datum der Veröffentlichung |
|---|---|---|---|
| US 2005156587 A1 | 21-07-2005 | US 2005156587 A1<br>US 2007057662 A1<br>US 2007063691 A1<br>US 2007205749 A1<br>US 2007205750 A1 | 21-07-2005<br>15-03-2007<br>22-03-2007<br>06-09-2007<br>06-09-2007 |
| US 2014218018 A1 | 07-08-2014 | CN 104981704 A<br>EP 2989473 A1<br>US 2014218018 A1<br>US 2015338444 A1<br>WO 2014124038 A1 | 14-10-2015<br>02-03-2016<br>07-08-2014<br>26-11-2015<br>14-08-2014 |
| US 2010001716 A1 | 07-01-2010 | AT 509280 T<br>CN 101384910 A<br>EP 1977258 A2<br>FR 2896591 A1<br>US 2010001716 A1<br>WO 2007085711 A2 | 15-05-2011<br>11-03-2009<br>08-10-2008<br>27-07-2007<br>07-01-2010<br>02-08-2007 |
| WO 2017116615 A1 | 06-07-2017 | CN 107407698 A<br>US 2017184635 A1<br>WO 2017116615 A1 | 28-11-2017<br>29-06-2017<br>06-07-2017 |

EPO FORM P0461

Für nähere Einzelheiten zu diesem Anhang : siehe Amtsblatt des Europäischen Patentamts, Nr.12/82